# EUROPEAN PATENT APPLICATION

(11) **EP 1 582 287 A1**
(43) Date of publication of application: **05.10.2005**
(21) Application number: 05251136.7
(22) Date of filing: 25.02.2005
(51) Int. Cl.: B23K 35/26, B23K 35/00, H01L 21/60, H05K 3/34

(54) **Soldered material, semiconductor device, method of soldering, and method of manufacturing semiconductor device**

(30) Priority: 31.03.2004 JP 2004103984
(71) Applicant: KABUSHIKI KAISHA TOSHIBA, Tokyo 105-8001 (JP)
(72) Inventor: Takahashi, Toshihide, c/o Toshiba Corporation, Tokyo 105-8001 (JP); Matsumoto, Kazutaka, c/o Toshiba Corporation, Tokyo 105-8001 (JP); Tadauchi, Masahiro, c/o Toshiba Corporation, Tokyo 105-8001 (JP); Komatsu, Izuru, c/o Toshiba Corporation, Tokyo 105-8001 (JP)
(74) Representative: Maury, Richard Philip

(57) **Abstract**

The soldered material relating to the present invention comprises a first metallic material to be soldered; a second metallic material to be soldered; and a soldering layer containing tin and a high melting point metal, interposed between the first metallic material and the second metallic material to solder both metallic materials together, wherein the second metallic material is materials selected from the groups consisting of copper, gold, silver, a gold and palladium based alloy containing gold and palladium as main constituents, and a silver and palladium based alloy containing silver and palladium as main constituents, and the soldering layer has a plurality of granular intermetallic compound phase composed of constituent elements for the second metallic material and tin being dispersed in a cross-sectional microstructure.

## Description

### CROSS-REFERENCE TO THE INVENTION

This application is based upon and claims the benefit of priority from the prior Japanese Patent Application No. 2004-103984 filed on March 31st, 2004; the entire contents of which are incorporated herein by reference.

### BACKGROUND

### 1. FIELD OF THE INVENTION

The present invention relates to soldering material suitably used especially for soldering between parts of electronic device, between metals, material metalized with metal on the surface and metal, between plural materials metalized with metal on the surface, a method of soldering, a semiconductor device using the same, and a method of manufacturing the semiconductor device.

### 2. DESCRIPTION OF THE RELATED ART

Solder joint which is a soldering technology of a certain material and another material having a melting point lower than that of the above material has been in use for a long time, and has been widely used in the soldering of electronic devices including soldering of semiconductor elements or electronic parts such as microprocessors, memory chips, resistors, capacitors and so on with a packaging substrate. The solder joint has a merit of not only fixing a part to a substrate but also serving as electrical connection by making a solder contain metals having conductivity.

Nowadays, with the rapid popularization of personal electronic devices and equipment such as personal computers, cellular phones and the like, the selection of soldering material or a method of soldering in a packaging technology of electronic parts has become of increasing importance.

Hitherto, the most popular solder has been a tin-lead based eutectic alloy solder. This tin-lead based eutectic solder is extremely suitable for practical use. However, it has been known that lead contained in the tin-lead based eutectic solder is harmful to a human body, which makes the development of a substance containing no lead, or a so-called non-lead based solder which can take the place of the tin-lead based eutectic solder as an urgent subject.

On the other hand, in soldering material used at present in semiconductor devices, for instance, used in a power device, a low-temperature type solder (Sn-Pb eutectic solder) of which melting point is about 183°C or below, and a high-temperature type solder (Pb-5Sn solder) of which melting point is about 300°C or above are mainly used differently according to respective processes.

As for the low-temperature type solders of the two, mainly tin, silver, and copper based alloy has reached in a practical stage and it is expected that many set makers will complete replacement into non-lead eutectic solders in several years.

However, as for a high-temperature type solder, namely, soldering material to form a soldered portion to maintain good mechanical strength even at high temperatures, for instance, at 260°C, a promising candidate material except high lead content material has not been found yet.

When intending to develop a metal alloy having a melting point of about 300°C using metallic material containing no harmful substance such as lead or the like, either making a tin-base alloy containing mainly tin with a melting point of 232°C into a material having a higher melting point, or making a zinc-base alloy containing zinc with a melting point of 420°C into material having a lower melting point is conceivable. However, material capable of forming a soldered portion which can sufficiently maintain mechanical strength at high temperatures has not been found from development of these alloys.

As a technology of forming a soldered portion which can maintain good mechanical characteristics under high temperature conditions, a method of changing a soldered portion into an intermetallic compound to improve heat-resistance has been proposed, for instance, "Reactivity to form intermetallic compounds in the micro joint using Sn-Ag solder" (13th Micro Electronics Symposium Research Papers (2003) pp. 45-48). However, this method needs to change the whole interface of the microjoining portion into an intermetallic compound, it requires a long duration time to allow the compound sufficiently grow, for instance, about 30 minutes to one hour for mounting the device. Besides, due to brittleness of intermetallic compound, mechanical reliability of the soldered portion is inferior and it is feared that thermal conductivity and electric resistance will be deteriorated.

### SUMMARY OF THE INVENTION

An object of the present invention is to provide: a soldering material which can obtain a soldered material in a short period of time using soldering material not containing lead in high concentration, of which soldered portion can maintain still in good mechanical strength even at high temperatures; a method of soldering; a semiconductor device which can obtain a soldered material in which the soldered portion between a semiconductor element and a lead frame can maintain good mechanical strength even at high temperatures using a soldering material not containing lead in high concentration in a short period of time; and a method of manufacturing the semiconductor device.

A soldered material in one aspect of the present invention includes a first metallic material to be soldered, a second metallic material to be soldered, and a soldering layer containing tin and a high melting point metal, interposed between the first metallic material and the second metallic material to solder both metallic materials together; the second metallic material is material selected from the groups consisting of copper, gold, silver, a gold and palladium based alloy containing gold and palladium as main constituents, and a silver and palladium based alloy containing silver and palladium as main constituents; and the soldering layer further has a plurality of granular intermetallic compound phases composed of constituent elements for the second metallic material and tin being dispersed in a cross-sectional microstructure.

In the soldered material, the soldering layer may further contain at least one kind of phase out of a solid solution phase containing the constituent elements for the second metallic material and tin, and a tin phase in a cross-sectional microstructure. Further, in the soldered material, the first metallic material is desirably selected from the groups consisting of copper, gold, silver, a gold and palladium based alloy containing gold and palladium as main constituents, and a silver and palladium based alloy containing silver and palladium as main constituents.

Moreover, in another aspect of the present invention, a semiconductor device includes a semiconductor element at least one surface of which is metalized with a metal thin film, a metallic lead frame on which the semiconductor element is mounted, a soldering layer containing tin and a high melting point metal, interposed between the metalized face of the metal thin film of the semiconductor element and the metallic lead frame to solder the semiconductor element and the metallic lead frame, and a sealing resin to seal the semiconductor element and the metallic lead frame; the metallic lead frame is composed of material selected from the groups consisting of copper, gold, silver, a gold and palladium alloy containing gold and palladium as main constituents, and a silver and palladium based alloy containing silver and palladium as main constituents; and the soldering layer further has a plurality of granular intermetallic compound phases composed of at least one kind of constituent element forming the metallic lead frame and tin as constituent elements being dispersed in a cross-sectional microstructure.

In the semiconductor device, the soldering layer may contain at least one kind of phase out of a solid solution phase containing the constituent elements for the metallic lead frame and tin and a tin phase being dispersed in a cross-sectional microstructure. Further, in the semiconductor device, the metal thin film desirably uses material selected from the groups consisting of copper, gold, silver, a gold and palladium based alloy containing gold and palladium as main constituents, and a silver and palladium based alloy containing silver and palladium as main constituents.

Furthermore, a method of soldering in another aspect of the present invention includes forming a laminate body by laminating a first metallic material to be soldered, and a second metallic material to be soldered having at least 50 µm or more in thickness and made of material selected from the groups consisting of copper, gold, silver, a gold and palladium based alloy containing gold and palladium as main constituents, and a silver and palladium based alloy containing silver and palladium as main constituents, with a thin layered film soldering material having a thickness in the range from 1 µm to 50 µm using tin or a tin-containing alloy; and soldering the first metallic material and the second metal material to each other by heating the laminate body at a temperature in the range from 280°C to 450°C.

In the soldering method, it is desirable to use materials as the tin-containing alloy, selected from the groups consisting of a tin and silver based alloy containing tin and silver as main constituents, a tin, silver and copper based alloy containing tin, silver, and copper as main constituents, a tin and copper based alloy containing tin and copper as main constituents, and a tin and zinc based alloy containing tin and zinc as main constituents in forming the laminate body. Further in the soldering method, a material having a liquidus temperature of 230°C or below may be used as a tin-containing alloy in forming the laminate body. Moreover, in the soldering method, it is desirable to heat the laminate body at a temperature from 300°C to 450°C in the soldering process. Furthermore, in the soldering method, it is desirable to heat the laminate body for 5 seconds or longer in the soldering process. And in the soldering method, materials selected from the groups consisting of copper, gold, silver, a gold and palladium based alloy containing gold and palladium as main constituents, and a silver and palladium based alloy containing silver and palladium as main constituents can be used as the first metallic

Another aspect of the present invention relates to a method of manufacturing a semiconductor device. The method of manufacturing a semiconductor device includes forming a laminate body by laminating a semiconductor element having a metal thin film metalized at least on one surface, and a lead frame of 50 µm in thickness or more to mount the semiconductor element using materials selected from the groups consisting of copper, gold, silver, a gold and palladium based alloy containing gold and palladium as main constituents, and a silver and palladium based alloy containing silver and palladium as main constituents interposing a thin layered soldering material having a thickness of 1 µm to 50 µm using tin or a tin-containing alloy in a manner that the metalized surface with the metal thin film of the semiconductor element faces the previously-described lead frame each other; soldering the semiconductor element and the lead frame with each other by heating the laminate body at a temperature from 280°C to 450°C; and sealing the soldered material with resin.

In the method of manufacturing the semiconductor device, it is desirable to use material selected from the groups consisting of a tin and silver based alloy containing tin and silver as main constituents, a tin, silver and copper based alloy containing tin, silver, and copper as main constituents, a tin and copper based alloy containing tin and copper as main constituents, and a tin and zinc based alloy containing tin and zinc as main constituents as a tin-containing alloy in forming the laminate body. And in a method of manufacturing the semiconductor device, it is desirable to use a material having a liquidus temperature of 230°C or below as the tin-containing alloy in forming the laminate body. Further, in the method of manufacturing the semiconductor device, it is desirable to heat the laminate body at a temperature from 300°C to 450°C in the soldering process. And in the method of manufacturing the semiconductor device, it is desirable to heat the laminate body for 5 seconds or longer in the soldering process.

In a method of manufacturing the semiconductor device, it is desirable to use materials selected from the groups consisting of copper, gold, silver, a gold and palladiumbased alloy containing gold and palladium as main constituents, and a silver and palladium based alloy containing silver and palladium as main constituents, as a metal thin film in forming of the laminate body.

The soldered material in the aspect of the present invention has sufficient soldering strength even when a harmful high lead content soldering material is not used, and can maintain mechanical strength even at high temperatures.

According to a method of soldering in the aspect of the present invention, a soldered portion having high heat resistance can be formed using a tin-base soldering material without any harmful high lead content, even though time to keep the solder at the peak soldering temperature is a short period of time.

In short, since the method of soldering in the aspect of the present invention makes it possible to solder in a short period of time, it contributes to improvement in manufacturing efficiency of a soldered material. For instance, in a practical packaging process of a semiconductor device, the same manufacturing speed as the current manufacturing speed with lead-containing solder can be set, so that the manufacturing efficiency is not reduced.

According to the method of manufacturing the semiconductor device and the semiconductor device itself in the aspect of the present invention, it is possible to provide a highly reliable semiconductor device in a short period of time, in which soldering strength between the semiconductor element and a lead frame can be maintained under exposure at high temperatures even without using a harmful high lead content soldering material during the manufacturing processes of the semiconductor device. Therefore, the present invention is extremely useful from the industrial point of view, and from the environmental protection point of view.

### BRIEF DESCRIPTION OF THE DRAWINGS

Fig. 1 is a sectional view showing one example of a soldered material.
Fig. 2 is a schematic sectional view showing an example of a soldered layer.
Fig. 3A to Fig. 3D are sectional views showing examples of a soldering method.
Fig. 4 is a sectional view showing another example of the soldering method.
Fig. 5 is a sectional view showing a soldered state between a semiconductor element and a lead frame in the embodiment.
Fig. 6 is a SIM observation image showing a cross-sectional microstructure of the soldering layer obtained by the Example 4.
Fig. 7 is a SIM observation image showing a cross-sectional microstructure of the soldering layer obtained by the Example 5.
Fig. 8 is a SIM observation image showing a cross-sectional microstructure of the soldering layer obtained by the Example 6.
Fig. 9 is a SIM observation image showing a cross-sectional microstructure of the soldering layer obtained by the Example 7.

### DESCRIPTION OF THE EMBODIMENTS

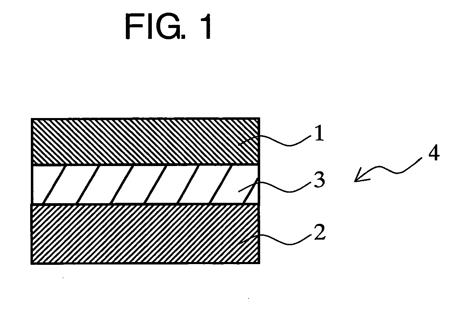

Fig. 1 is a sectional view showing a example of a soldered material in one embodiment of the present invention. The soldered material 4 is composed of a first metallic material to be soldered being soldered to a second metallic material 2 to be soldered via a soldering layer 3.

As for the first metallic material 1 to be soldered, a metal is used. The metal can be selected depending on the usage and there is no specific limitation, but it is desirable to use a material easy to dissolve in molten tin under high temperature conditions. Concretely, it is desirable to use materials selected from the groups consisting of copper, gold, silver, a gold and palladium based alloy, and a silver and palladium based alloy, similarly to the second metallic material to be soldered which will be described later, so that a soldered portion excellent in heat resistance can be formed. In addition to these materials, zinc, a gold and tin alloy, a palladium and nickel alloy can be cited as concrete examples.

It is inevitably required to use materials selected from the groups consisting of copper, gold, silver, a gold and palladium based alloy containing gold and palladium as main constituents, and a silver and palladium based alloy containing silver and palladium as main constituents as for the second metallic material 2 to be soldered, and the material to be soldered is selected depending on the usage. These elements and alloys easily cause dissolving and diffusing into a soldering material containing tin by being heated at high temperatures, and intermetallic compounds with tin can be easily formed. Among them, especially gold and silver are desirable in terms of solubility into molten tin.

A desirable composition for a gold and palladium based alloy containing gold and palladium as main constituents contains 50 wt% to 90 wt% of gold, 30 wt% to 50 wt% of palladium, and total sumof gold and palladium is 100 wt % or less, and it is also acceptable to contain other elements, for instance, 0 wt% to 10 wt% of nickel, tin, cobalt, and so on. As a concrete example of the compositional range of the gold and palladium based alloy, 60Au-40Pd can be cited.

A desirable composition for a silver and palladium based alloy containing silver and palladium as main constituents contains 50 wt% to 90 wt% of silver, 30 wt% to 50 wt% of palladium, and total sum of silver and palladium is 100 wt% or less, and it is also acceptable to contain other elements, for instance, 0 wt% to 10 wt% of nickel, tin, cobalt, and so on. As a concrete example of the compositional range of the silver and palladium based alloy, 60Ag-40Pd can be cited.

In a cross-sectional microstructure of the soldering layer 3 soldering the first metallic material 1 to be soldered and the second metallic material 2 to be soldered, there are a tin-base phase, namely, a solid solution phase containing at least element composing the second metallic material to be soldered and tin, or a tin phase, or these both phases. And, in the cross-sectional microstructure of the soldering layer 3, a plurality of granular intermetallic compound phase composed of at least one kind of element composing the second metallic material to be soldered and tin are further in existence.

In short, the soldering layer 3 takes a form that an intermetallic compound phase having a high melting point is dispersed in a granular state in a tin-base phase having a low melting point, which is excellent in wettability with metal. By taking this structure, when the soldering layer 3 is heated to a high temperature, for instance, when it is placed under a condition at a temperature of 260°C or higher, not all of the soldering layer 3 is changed into a liquid phase, and a sherbet state in which a liquid phase and a solid phase are mixed is maintained. Accordingly, mechanical strength of the soldered portion is considered to be maintained.

When the whole soldering layer is changed into an intermetallic compound, though a melting point of the soldered portion becomes high, since the intermetallic compound itself is high in brittleness, the solder becomes brittle, so that the mechanical strength may not be maintained. However, according to the embodiment of the present invention, a soldered portion which is excellent in heat resistance can be obtained without causing such a problem.

Besides, when a dispersed intermetallic compound phase has a needle shape, it may cause crack of the solder joint so that maintenance of the mechanical strength is likely to be failed.

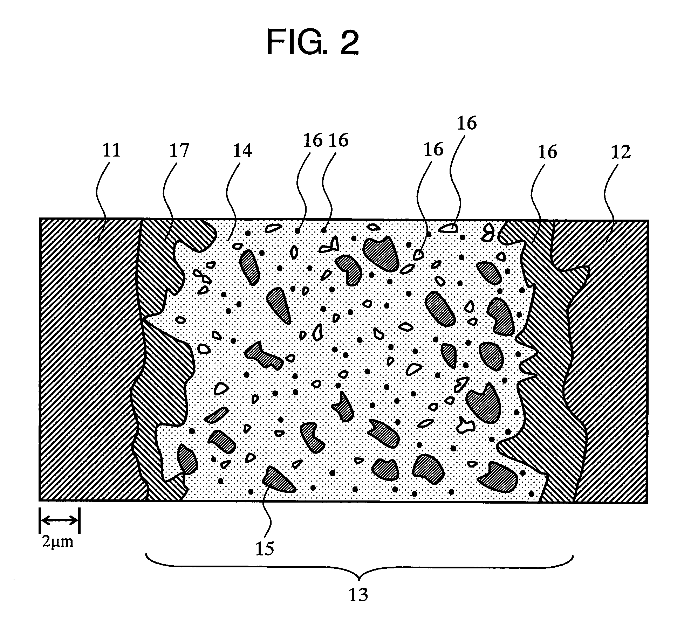

Fig. 2 is a schematic sectional view showing an example of the soldering layer 3. A soldering layer 13 shown in Fig. 2 is a view in a schematic diagram of SIM observation result of a cross section of the soldered material obtained as below. The soldered material is obtained in a manner that copper plates having a thickness of 300 µm are used as both of a first metallic material to be soldered and a second metallic material to be soldered, a laminate body is formed by interposing tin foil as a soldering material between the first and second metallic materials to be soldered, and the laminate body is heated for 30 seconds of heating time at a peak temperature of 300°C for 10 seconds.

As shown in Fig. 2, in a soldering layer 13, between a first metallic material 11 to be soldered and a second metallic material 12 to be soldered, there were a solid solution phase 14 in which copper being a constituent element at least for the first and second metallic materials to be soldered is dissolved in tin and a tin phase 15 which contains no constituent elements for the second metallic material to be soldered. And in the soldering layer 13, a granular intermetallic compound phase 16 composed of copper being a constituent element for the first and second metallic materials to be soldered and tin was dispersed. In this example, the intermetallic compound layer was Cu₆Sn₅. It is considered that the brittleness of the soldering layer 13 can be reduced due to dispersion of the intermetallic compound phase 16. Further, in the interface between the first metallic material 11 to be soldered or the second metallic material 12 to be soldered and the soldering layer 13, a scallop shaped intermetallic compound phase 17 composed of the constituent elements for the first and second metallic materials to be soldered and tin was in existence.

In the soldered material of the embodiment of the present invention, the scallop shaped intermetallic compound phase composed of the constituent elements for the first and/or second metallic material (s) to be soldered and tin may or may not be in existence in the interface between the first metallic material to be soldered or the second metallic material to be soldered and the soldering layer. However, when the scallop shaped intermetallic compound is too rich, it may reduce the soldering strength. Therefore, it is desirable that the intermetallic compound exists in an amount as small as possible. Concretely, the average thickness is desirably one half of the average thickness of the soldered portion.

In the example shown in Fig. 2, the second metallic material to be soldered is composed of a single kind of element, but when the second metallic material to be soldered is composed of two kinds or more of elements , some or all elements out of the constituent elements for the second metallic material to be soldered may be contained in the solid solution phase containing the constituent elements for the second metallic material to be soldered and tin.

When the second metallic material to be soldered is composed of two kinds or more of elements, the granular intermetallic compound composed of the constituent elements for the second metallic material to be soldered and tin may be also composed of some or all elements out of the constituent elements for the second metallic material to be soldered.

Though the first metallic material to be soldered and the second metallic material to be soldered use the same kinds of materials, when the first metallic material to be soldered and the second metallic material to be soldered use different kinds of materials, some or all elements out of the constituent elements for the first metallic material to be soldered may be further contained in the solid solution phase containing the constituents elements for the second metallic material to be soldered and tin.

And when the first metallic material to be soldered and the second metallic material to be soldered use different kinds of materials, the granular intermetallic compound composed of the constituent elements for the second metallic material to be soldered and tin may contain some or all elements out of the constituent elements for the first metallic material to be soldered as the constituent elements.

Furthermore, when the first metallic material to be soldered and the second metallic material to be soldered use different kinds of materials, a phase containing the constituent elements for the first metallic material to be soldered and tin, or an intermetallic compound phase composed of the constituent elements for the first metallic material to be soldered and tin may be in existence.

The granular intermetallic compound desirably exists in an area ratio from 5% to 20% so far as the soldering layer can be observed. When the granular intermetallic compound phase is in this range, the mechanical strength of the soldered portion can be maintained and the improving effect in heat resistance is great.

The average particle size of of the granular intermetallic compound phase so far as it is observed is desirably in the range from 0.1 µm to 5 µm. When the granular intermetallic compound phase is in this range, the mechanical strength of the soldered portion can be maintained and the improving effect in heat resistance is great.

The shape of the granular intermetallic compound phase is not limited in particular. In order to enhance the soldering strength at high temperatures, it is desirable that the range of the ratio of the shorter diameter to the longer diameter is des irably in the range of 1:1 to 1:3. Unevenness on the surface thereof are also acceptable.

In order to obtain the above-described soldered material, it is possible to obtain the soldered material by carrying out a method of soldering described in detail below, but it is not limited to this method.

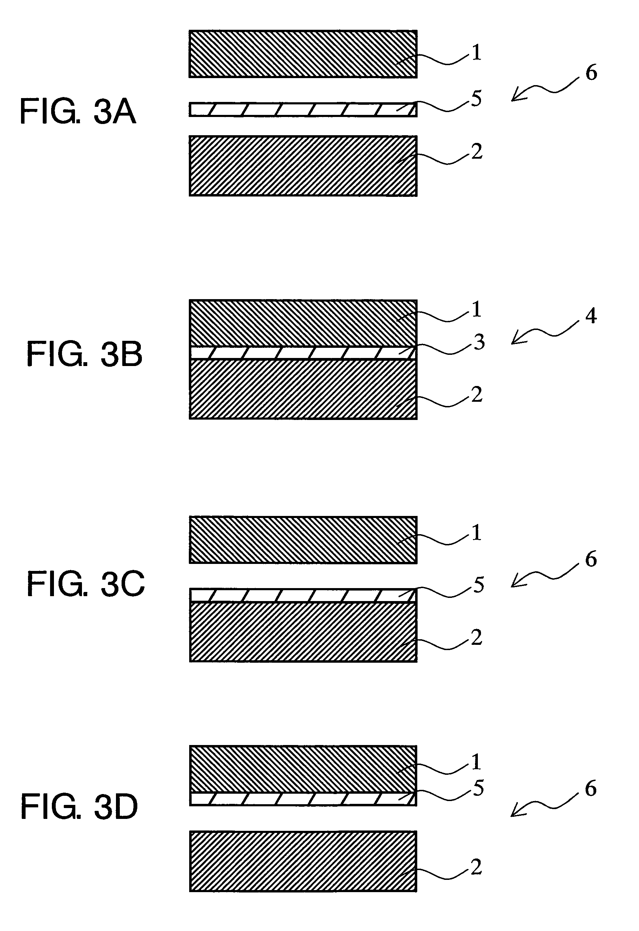

Fig. 3A to Fig. 3D are sectional views showing examples of a soldering method in another embodiment of the present invention. Firstly, as shown in Fig. 3A, the first metallic material 1 to be soldered, a thin layered soldering material 5, and the second metallic material 2 to be soldered are laminated to form a laminate body 6. Pressure may be applied at this time.

Next, by heating the laminate body 6, a soldered material 4 in which the first metallic material 1 to be soldered and the second metallic material 2 to be soldered are soldered via the

It should be noted that when obtaining the laminate body 6, as shown in Fig. 3C, a thin soldering material 5 is metalized on the surface of the second metallic material 2 to be soldered in advance, the laminate body 6 may be formed by laminating the first metallic material 1 to be soldered on a state that the surface of the second metallic material 2 to be soldered is covered with the thin layered soldering material 5. Or, as shown in Fig. 3D, it is also acceptable that the surface of the firstmetallic material 1 to be soldered is metalized in advance, and the body in which the thin layered soldering material 5 is covered with the surface of the first metallic material 1 to be soldered and the second metallic material 2 to be soldered are laminated to form the laminate

It is also within the category of the embodiment of the present invention that the first metallic material to be soldered or the second metallic material to be soldered is metalized on the surface of other member made of metal, ceramics, semiconductor, or the like, and used as a member to solder the first or the second member to be soldered with other member.

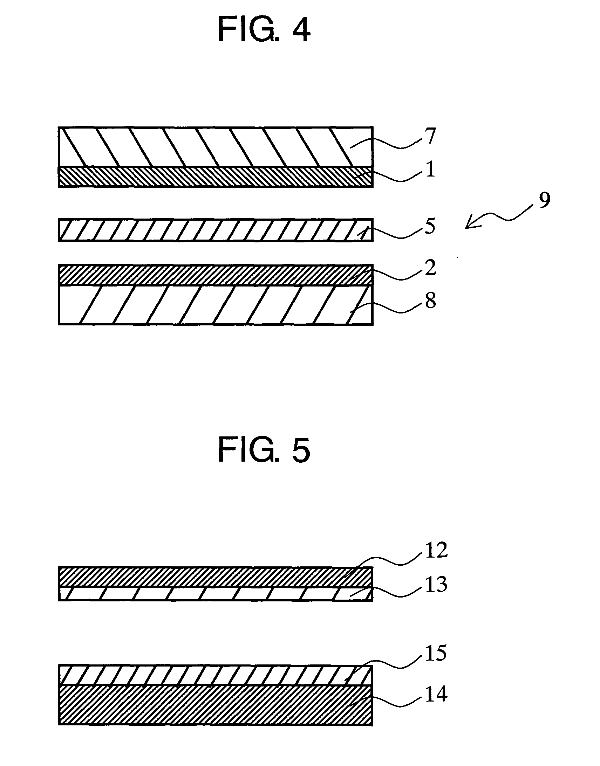

Fig. 4 is a sectional view showing another example of the soldering method. The first metallic material 1 to be soldered is metalized on the surface of a base material 7, and the second metallic material 2 to be soldered is metalized on the surface of a base material 8. The thin layered soldering material 5 is disposed between respective metalized layers to form a laminate body 9. Soldering is performed by heating the laminate body 9. It should be noted that when both the base material 8 and a metalized layer 2 are material selected from the groups consisting of copper, gold, silver, a gold and palladium based alloy containing gold and palladium as main constituents, and a silver and palladium based alloy containing silver and palladium as main constituents, a laminate body of the base material 8 and the metalized layer 2 is regarded as the second metallic material to be soldered.

In Fig. 4, an example of both the first metallic material to be soldered and the second metallic material to be soldered are metalized on the surfaces of other base materials is shown, but the case that only the first metallic material to be soldered is metalized on the surface of another base material and the second metallic material to be soldered is not metalized on another base material is also in the category of the embodiment of the present invention. On the contrary, the case that only the second metallic material to be soldered is metalized on the surface of another base material and the first metallic material to be soldered is not metalized on another base material is also in the category of the embodiment of the present invention.

As a method of metalizing the first and second metallic materials to be soldered on the surfaces of other material, vapor deposition, plating process, electron-beam process, and so on can be cited.

Members used for the above-described soldering method will be further explained below. Metallic material is used for the first metallic material to be soldered. Though the metallic material can be selected according to the usage, and there is no limitation in particular, it is desirable to use material which easily dissolves into molten tin at high temperatures. Concretely, when it is selected from the groups consisting of, desirably, copper, gold, silver, a gold and palladium alloy, and a silver and palladium alloy, similarly to the second metallic material to be soldered as will be described later, a soldered portion excellent in heat resistance can be obtained. In addition to those materials, zinc, a gold and tin alloy, a palladium and nickel alloy and so on can be cited as a concrete example.

The second metallic material 2 to be soldered is inevitably materials selected from the groups consisting of copper, gold, silver, a gold and palladium alloy containing gold and palladium as main constituents, and a silver and palladium alloy containing silver and palladium as main constituents. Those elements are apt to dissolve or diffuse into a thin layered soldering material containing tin by heating at high temperatures, and easily form an intermetallic compound with tin. Especially, gold and silver are desirable in terms of solubility into molten tin.

A desirable composition for a gold and palladium based alloy containing gold and palladium as main constituents contains 50 wt% to 90 wt% of gold, 30 wt% to 50 wt% of palladium, and total sumof gold and palladium is 100 wt% or less, and it is also acceptable to contain other elements, for instance, 0 wt% to 10 wt% of nickel, tin, cobalt, and so on. As a concrete example of the compositional

A desirable composition for a silver and palladium based alloy containing silver and palladium as main constituents contains 50 wt% to 90 wt% of silver, 30 wt% to 50 wt% of palladium, and total sum of silver and palladium is 100 wt% or less, and it is also acceptable to contain other elements, for instance, 0 wt% to 10 wt% of nickel, tin, cobalt, and so on. As a concrete example of the compositional range of the silver and palladium based alloy, 60Ag-40Pd can be cited.

When the first metallic material to be soldered is composed of material other than the material selected from the groups consisting of copper, gold, silver, a gold and palladium alloy, and a silver and palladium alloy, the thickness (average thickness) of the first metallic material to be soldered is desirably in the range from 1 µm to 100 µm. And when the first metallic material to be soldered is material selected from the groups consisting of copper, gold, silver, a gold and palladium alloy, and a silver and palladium alloy, the thickness of the first metallic material to be soldered is desirably in the range from 1 µm to 100 µm.

The thickness (average thickness) of the second metallic material to be soldered is required to be 50 µm or more. If it is less than 50 µm, diffusion of the elements into the tin alloy is not occurred sufficiently in the soldering layer, a soldered portion having heat resistance is not likely to be formed. And the thickness of the second metallic material to be soldered is

For instance, when the metalized layer 2 is formed on the base material 8 as shown in Fig. 4, if the base material 8 and the metalized layer 2 are materials selected from the groups consisting of copper, gold, silver, a gold and palladium alloy containing gold and palladium as main constituents, and a silver and palladium alloy containing silver and palladium as main constituents, a laminate body of the base material 8 and the metalized layer 2 is regarded as the second metallic material 2 to be soldered, and it is sufficient if the sum in thickness of the metalized layer 2 and the base material 8 is 50 µm or more.

Besides, for instance, in the case that a metalized layer 2 is formed on the base material 8 as shown in Fig. 4, if the base material 8 is other than the material selected from the groups consisting of copper, gold, silver, a gold and palladium alloy containing gold and palladium as main constituents, and a silver and palladium alloy containing silver and palladium as main constituents, and when the second metallic material 2 to be soldered is metalized on the base material 8 to use to solder the base material 8, the thickness is required to be 50 µm or more, desirably 100 µm or less.

As a thin layered soldering material, tin or a tin-containing alloy having a liquidus temperature of 230°C or below is used. As a tin-containing alloy having a liquidus temperature of 230°C or below, a tin and silver based alloy containing tin and silver as main constituents, a tin, silver and copper based alloy containing tin, silver and copper as main constituents, a tin and copper based alloy containing tin and copper as main constituents, or a tin and zinc based alloy containing tin and zinc as main constituents is desirable. Concrete compositional examples of a tin-containing alloy having a liquidus temperature of 230°C or below are as follows.
A tin and silver based alloy : 0.1 wt% or more to 5.0 wt% or less of silver, the remainder is Sn;
A tin and copper based alloy : 0.1 wt% or more to 1.0 wt% or less of copper, the remainder is Sn;
A tin, silver and copper based alloy : 0.1 wt% or more to 5.0 wt% or less of silver, 0.1 wt% or more to 1.0 wt% or less of copper, the remainder is Sn; and
A tin and zinc based alloy : 0.1 wt% or more to 15.0 wt% or less of zinc, the remainder is Sn.
It is also acceptable if 0 wt% or more to 10 wt% or less of element such as copper, zinc, nickel, bismuth, indium is contained.

In order to appropriately fulfill both needs of securing solderability of the soldering material and improvement of heat resistance due to diffusion of the material to be soldered, the thickness of the thin layered soldering material is desirably in the range from 1 µm to 50 µm, desirably from 3 µm to 15 µm, more preferably 5 µm to 10 µm. If the thickness of the thin layered soldering material is too thick, the material to be soldered does not sufficiently diffuse into the soldering material within the soldering time, so that improvement of heat resistance may not be realized. If it is too thin, wettability of the soldering material lowers, so that the soldering strength may not be secured.

As for a means for supplying a thin layered shape, a plating process, soldering paste, sheet solder, solder precoat by the Super Juffit Process (developed by Showa Denko K.K.) and the Super Solder Method (developed by Harima Chemicals, INC.) and the like can be cited.

In the case of using soldering paste, as for the thickness of the soldering paste, when it is excessively large, the material to be soldered does not diffuse to the tin dominant layer portion sufficiently within the soldering time of several seconds, therefore, making the material to have a high melting point is considered to be unrealized. Accordingly, in order to appropriately fulfill both needs of securing solderability and realizing a high melting point in a short period of time, it is desirable to make the thickness of the soldering paste in the range of 10 µm to 50 µm, more desirably 10 µm to 30 µm so as to make the thickness of the soldering paste as thin as possible.

In the case of using sheet soldering material, when the thickness of the sheet is excessively large, the material to be soldered does not diffuse to the tin dominant layer portion sufficiently within the soldering time of several seconds, therefore, making the material to have a high melting point is considered to be unrealized. Accordingly, in order to appropriately fulfill both needs of securing solderability and realizing a high melting point in a short period of time, it is desirable to make the thickness of the sheet soldering material in the range of 30 µm to 50 µm.

A method of soldering according to the embodiment of the present invention will be further explained. The heating temperature at the time of heating the laminate body is in the range from 280°C to 450°C. When it is in this range, the thin layered soldering material containing tin having a melting point of 232°C as a main constituent is melted, into which the second metal material to be soldered keeping its solid phase state is melted and diffused to form a granular intermetallic compound. The temperature of heating is desirably in the range from 300°C to 450°C, more desirably from 400°C to 450°C.

The time of heating is desirably 5 seconds or more, and it is more desirable that especially the heating time at the peak temperature is 5 seconds or more. The time of heating is 2 minutes or less at the longest, and it is desirable to heat for one minute or less at the peak temperature, and more desirably, 30 seconds or less.

According to the method of soldering of the embodiment of the present invention, when the second metallic material to be soldered having a specific composition and being relatively large in thickness, and a thin layered soldering material having a specific composition and being thin in thickness are used, and by heating them at a high temperature of 280°C or more, the thin layered soldering material containing tin having a melting point of 232°C as a main constituent is melted, into which at least the second metallic material to be soldered keeping a solid phase state is dissolved and diffused. The diffusion phase of the material to be soldered is dominant inside the soldering layer so that a high melting point of the solder can be realized. In other words, by removing a tin-phase portion which is low in melting point, even under a high temperature of 260°C which is required as a 260°C guarantee for a high temperature type mounting material, the soldering layer is not melted again. In the thin layered soldering material, not only a tin phase, but also a phase in which at least the constituent elements for the second metallic material to be soldered is dissolved into tin and an intermetallic compound phase composed of tin and at least the constituent elements for the second metallic material to be soldered and the like are formed in a soldering layer formed by diffusion of at least the second metallic material to be soldered. As a result, a soldered material excellent in mechanical strength even at high temperatures can be obtained in a short period of time for 1 munite or less.

The soldered material and the method of soldering according to the embodiment of the present invention can be used in any fields, it is especially suitably used for parts for electronic equipment placed at high temperatures during the manufacturing process or using such a product, and for soldering of parts in semiconductor devices, especially in power type semiconductor devices. It is particularly suitable to use especially for soldering a semiconductor element and a lead frame.

### (Example)

The embodiment of the present invention will be explained in more details by examples as below.

### (Example 1)

Soldering of a semiconductor element and a lead frame in a power type semiconductor device was carried out. Fig. 5 is a sectional view showing an embodiment of soldering of the semiconductor element and the metallic lead frame. In this power type semiconductor module, metalizing was performed by vapor depositing gold on a 10 mm square silicon semiconductor element 21 to form a metal layer 22 (first metallic material to be soldered) made of gold having 0.1 µm in thickness. A 5 µm thick thin layer 24 made of tin was coated as a thin layered soldering material by plating on the lead frame 23 (the second metallic material to be soldered) made of copper. The silicon semiconductor element 21 covered by the metal layer 22 and the lead frame 23 covered by the tin thin layer 24 were put in layers so that the metal layer 22 and the tin thin layer 24 come in contact with each other and soldered thereafter by heating. The heating was to reflow in nitrogen atmosphere with oxygen concentration controlled to 100 ppm or less. The reflow temperature was preheating at 200°C for about 30 seconds, and main heating at 320°C for about 10 seconds.

When observing the cross sections of soldered interface with SEM after soldering, no remarkable void was detected and good solder joint was created.

The lead frame and the semiconductor element which were soldered together lastly was sealed with resin to obtain a power type semiconductor device.

### (Example 2)

In this example, similarly to Example 1 except that a thin layered soldering material 24 was formed on the lead frame 23 by soldering paste printing, a power type semiconductor device was obtained.

Using a tin and silver based alloy composed of 3.5 wt% of silver and the remainder of tin, a solder powder of about 5 µm was prepared. The solder powder material and a flux components were completely mixed at about 10% in weight ratio to form soldering paste. The flux components were solvent, rosin, detergent, organic halogen, viscous agent, and so on. The soldering paste was stirred for about 20 minutes until the viscosity of the soldering paste became about 500,000 cps which was a suitable viscosity for printing. The soldering paste was printed on a lead frame 23 made of copper so as to get about 30 µm in thickness of the print layer, and a semiconductor element 21 covered with a metal layer 22 made of gold formed by vapor deposition was mounted on the print layer of the lead frame 23 to reflow in nitrogen atmosphere with oxygen concentration controlled to 100 ppm or less. The reflow temperature was preheating at 200°C for about 30 seconds, and main heating at 320°C for 10 seconds.

When observing the cross sections of soldered interface with SEM after soldering, no remarkable void was detected and good solder joint was created.

The lead frame and the semiconductor element which were soldered together lastly was sealed with resin to obtain a power type semiconductor device.

### (Example 3)

In this example, similarly to Example 1 except that a thin layered soldering material 24 was formed by supplying sheet soldering material to a lead frame 23, a power type semiconductor device was obtained. The sheet soldering material is a sheet having about 50 µm in thickness using a tin and silver based alloy containing 3.5 wt% of silver and the remainder of tin. The sheet soldering material is disposed on the lead frame 23 composed of copper, and a silicon semiconductor element on which gold was vapor deposited was mounted to reflow in nitrogen atmosphere with oxygen concentration controlled to 100 ppm or less. The reflow temperature was preheating at 200°C for about 30 seconds, and main heating at 320°C for about 10 seconds.

When observing the cross sections of soldered interface with SEM after soldering, no remarkable void was detected and good solder

The lead frame and the semiconductor element which were soldered together lastly was sealed with resin to obtain a power type semiconductor device.

A soldered material was obtained as follows. A copper plate of 300 µm thick was used both for a first metallic material to be soldered and a second metallic material to be soldered in the soldered material, and a laminate body is formed by interposing a thin layered soldering material between the first, and second metallic materials to be soldered. Then, heating was performed to prepare soldered materials of Examples 4 to 9.

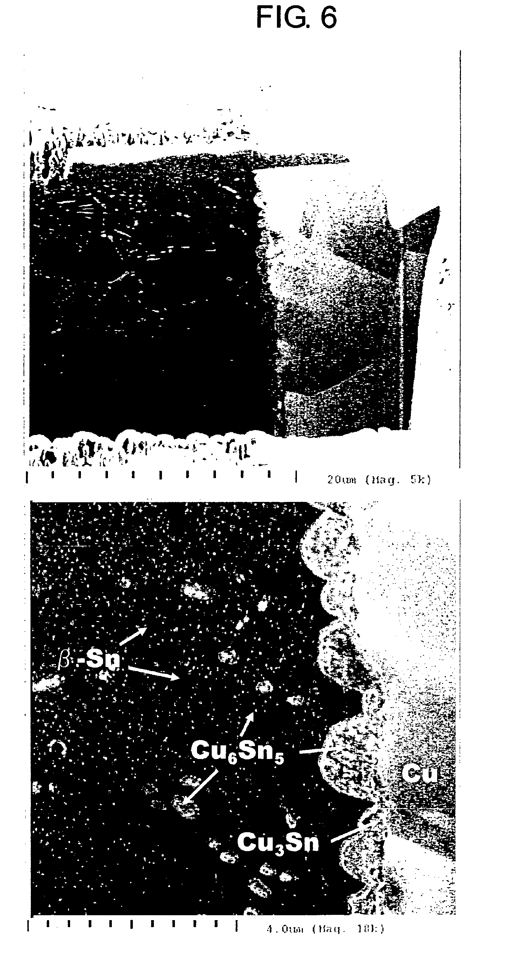

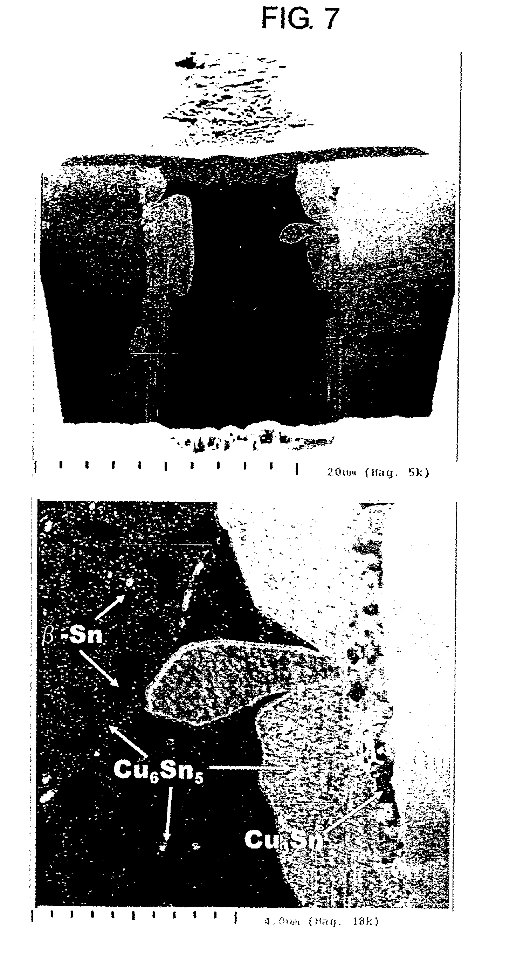

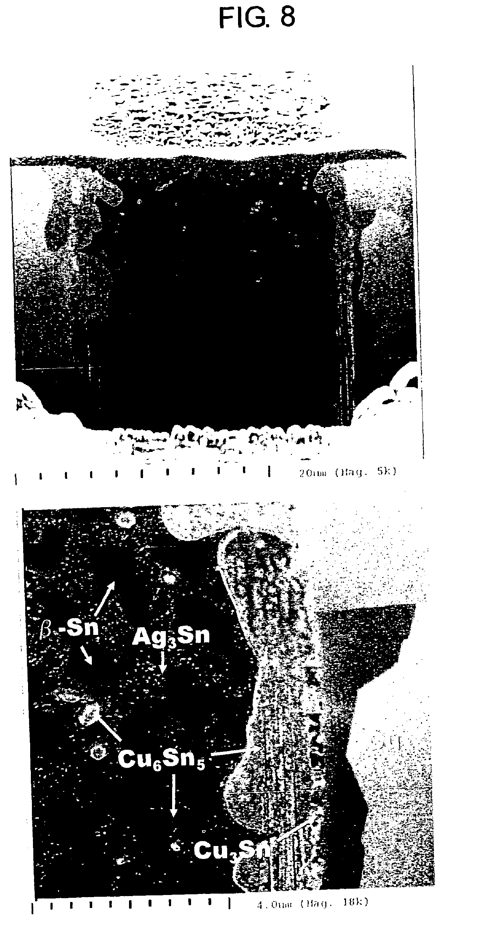

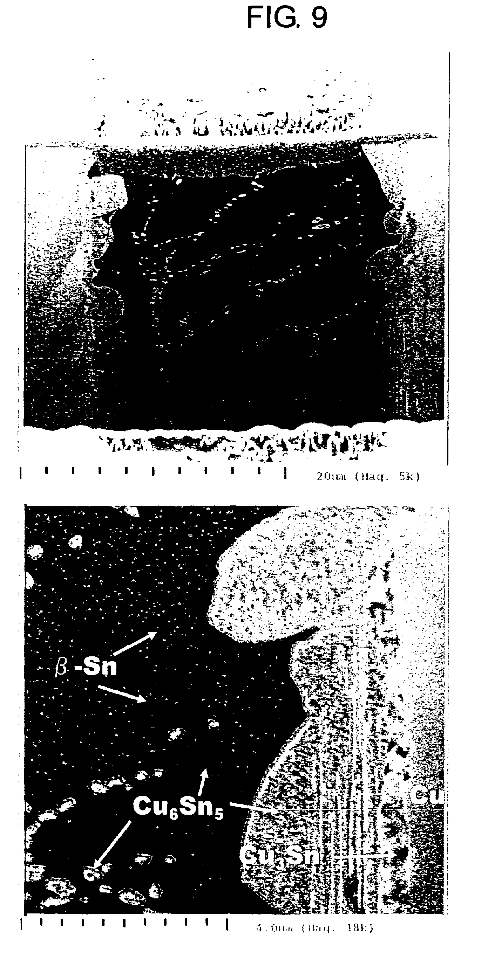

Thin layered soldering materials and heating conditions (peak temperature × peak temperature holding time) are described in Table 1. Thus obtained soldered material was evaluated in terms of soldering strength at 260°C in such a manner that whether or not its soldered face can be maintained by a peel test with a load of 10 Nf. The results are also described in Table 1 as a peeling strength. In the peeling strength described in Table 1, the case of no peeling of the soldered face after the test was marked with "OK", and the case of appearing the peeling was marked with "-". And using samples prepared by performing a FIB (Focused Ion Beam) processing on cross sections of soldered portions of thus obtained soldered materials, SIM observation images were obtained to carry out analysis of respective phases observed by EPMA (Electron Probe X-ray Microanalyzer) analysis. The SIM observation images are shown in Fig. 6 for Example 4, in Fig. 7 for Example 5, in Fig. 8 for Example 6, and in Fig. 9 for Example 7, respectively.

**[Table 1]**

| | Thin layer Soldering Material | Heating Condition (peak temp. × temp holding time | Peeling strength | Section SIM Observation Image |
|---|---|---|---|---|
| Example 4 | 10 µm in thick Sn plated | 300°C x 30 seconds | OK | Fig. 6 |
| Example 5 | 10 µm in thick Sn plated | 300°C x 60 seconds | OK | Fig. 7 |
| Example 6 | 10 µm in thick Sn-3.5Ag plated | 300°C x 30 seconds | OK | Fig. 8 |
| Example 7 | 10 µm in thick Sn-0.7Cu plated | 300°C x 30 seconds | OK | Fig. 9 |
| Example 8 | 10 µm in thick Sn-3.OAg-0.5Cu plated | 300°C x 30 seconds | OK | |
| Example 9 | 10 µm in thick Sn-9.0Zn plated | 300°C x 30 seconds | OK | |
| Comparative Example 1 | 10 µm in thick Sn plated | 250°C x 30 seconds | - | |
| Comparative Example 2 | 10 µm in thick Sn plated | 300°C x 30 seconds | - | |
| Comparative Example 3 | 10 µm in thick Sn-6. 0Ag plated | 300°C x 30 seconds | - | |
| Comparative Example 4 | 10 µm in thick Sn-2.0Cu plated | 300°C x 30 seconds | - | |
| Comparative Example 5 | 10 µm in thick Sn-18.0Zn plated | 300°C x 30 seconds | - | |

The tin base phase and the granular intermetallic compound phase exist in the soldering layer as shown in Fig. 6 to Fig. 9 according to Example 4 to Example 7. It is obvious that the soldered materials in Examples 4 to 7 having such a soldering layer are excellent in soldering strength. Moreover, also the soldered materials in Examples 8 and 9, the solder joints are excellent in soldering strength.

Comparative Example 1 is an example to perform soldering under the same condition as in Example 4 except the heating temperature is lower. A soldered material in Comparative Example 2 was obtained as follows. A pair of copper plates of 300 µm are prepared. A nickel layer of 10 µm thick is on a surface of one copper plate, on a surface of which further a gold layer of 10 µm thick were metalized by plating. On a surface of the other copper plate, a nickel layer of 10 µm thick is metalized by plating. A laminate body is formed by allowing the metalized surfaces of both copper plates facing each other and interposing a thin layered soldering material shown in Table 1 therebetween and the laminate body was heated under the condition shown in Table 1 to prepare a soldered material in Comparative Example 2. Comparative Example 3 to Comparative Example 5 are examples to perform soldering under the same condition as in Example 4 except that the used soldering materials are different.

## Claims

1. A soldered material, comprising:
a first metallic material to be soldered;
a second metallic material to be soldered; and
a soldering layer containing tin and a high melting point metal, interposed between said first metallic material and said second metallic material to solder both metallic materials together,
wherein said second metallic material is material selected from the groups consisting of copper, gold, silver a gold and palladium based alloy containing gold and palladium as main constituents, and a silver and palladium based alloy containing silver and palladium as main constituents; and
wherein said soldering layer further has a plurality of granular intermetallic compound phases composed of constituent elements for the second metallic material and tin being dispersed in a cross-sectional microstructure.

2. The soldered material according to claim 1,
wherein said soldering layer further contains at least one kind of phase out of a solid solution phase containing the constituent elements for the second metallic material to be soldered and tin, and a tin phase in a cross-sectional microstructure.

3. The soldered material according to claim 1,
wherein said first metallic material is material selected from the groups consisting of copper, gold, silver, a gold and palladium based alloy containing gold and palladium as main constituents, and a silver and palladium based alloy containing silver and palladium as main constituents.

4. A semiconductor device, comprising:
a semiconductor element at least one surface of which is metalized with a metal thin film;
a metallic lead frame on which said semiconductor element is mounted;
a soldering layer containing tin and a high melting point metal, interposed between a metalized face of the metal thin film of said semiconductor element and saidmetallic lead frame to solder said semiconductor element and said metallic lead frame; and
a sealing resin to seal said semiconductor element and said metallic lead frame,
wherein said metallic lead frame is composed of material selected from the groups consisting of copper, gold, silver, a gold and palladium based alloy containing gold and palladium as main constituents and a silver and palladium based alloy containing silver and palladium as main constituents, and
wherein said soldering layer further has a plurality of granular intermetallic compound phases composed of at least one kind of constituent element forming said metallic lead frame and tin as constituent elements being dispersed in a cross-sectional microstructure.

5. The semiconductor device according to claim 4,
wherein said soldering layer contains at least one kind of phase out of a solid solution phase containing the constituent elements for said metallic lead frame and tin and a tin phase being dispersed in a cross-sectional microstructure.

6. The semiconductor device according to claim 4,
wherein said metal thin film uses material selected from the groups consisting of copper, gold, silver, a gold and palladium based alloy containing gold and palladium as main constituents, and a silver and palladium based alloy containing silver and palladium as main constituents.

7. A method of soldering, comprising:
forming a laminate body by laminating a first metallic material to be soldered, and a second metallic material to be soldered having at least 50 µm or more in thickness and made of material selected from the groups consisting of copper, gold, silver, a gold and palladium based alloy containing gold and palladium as main constituents, and a silver and palladium based alloy containing silver and palladium as main constituents, with a thin layered soldering material having a thickness in the range from 1 µm to 50 µm using tin or a tin-containing alloy; and
soldering the first metallic material and the second metal material to each other by heating the laminate body at a temperature in the range from 280°C to 450°C.

8. The method of soldering according to claim 7,
wherein said laminate body forming process uses material selected from the groups consisting of a tin and silver based alloy containing tin and silver as main constituents, a tin, silver and copper based alloy containing tin, silver, and copper as main constituents, a tin and copper based alloy containing tin and copper as main constituents, and a tin and zinc based alloy containing tin and zinc as main constituents as the tin-containing alloy.

9. The method of soldering according to claim 7,
wherein said laminate body forming process uses material having a liquidus temperature of 230°C or below as the tin-containing alloy.

10. The method of soldering according to claim 7,
wherein said soldering process performs heating of the laminate body at a temperature from 300°C to 450°C.

11. The method of soldering according to claim 7,
wherein said soldering process performs heating of the laminate body for 5 seconds or longer.

12. The method of soldering according to claim 7,
wherein said laminate body forming process uses material selected from the groups consisting of copper, gold, silver, a gold and palladium based alloy containing gold and palladium as main constituents, and a silver and palladium based alloy containing silver and palladium as main constituents as the first metallic material to be soldered.

13. A method of manufacturing a semiconductor device, comprising:
forming a laminate body by laminating a semiconductor element having a metal thin film metalized at least on one surface, and a lead frame of 50 µm in thickness or more to mount the semiconductor element using material selected from the groups consisting of copper, gold, silver, a gold and palladium based alloy containing gold and palladium as main constituents, and a silver and palladium based alloy containing silver and palladium as main constituents interposing a thin layered soldering material having a thickness of 1 µm to 50 µm using tin or a tin-containing alloy in a manner that the metalized surface with the metal thin film of the semiconductor element faces the lead frame each other;
soldering the semiconductor element and the lead frame with each other by heating the laminate body at a temperature from 280°C to 450°C; and
sealing the soldered material with resin.

14. The method of manufacturing the semiconductor device according to claim 13,
wherein said laminate body forming process uses material selected from the groups consisting of a tin and silver based alloy containing tin and silver as main constituents, a tin, silver and copper based alloy containing tin, silver, and copper as main constituents, a tin and copper based alloy containing tin and copper as main constituents, and a tin and zinc based alloy containing tin and zinc as main constituents as the tin-containing alloy.

15. The method of manufacturing the semiconductor device according to claim 13,
wherein said laminate body forming process uses material having a liquidus temperature of 230°C or lower as a tin-containing alloy.

16. The method of manufacturing the semiconductor device according to claim 13,
wherein said soldering process performs heating of the laminate body at a temperature from 300°C to 450°C.

17. The method of manufacturing the semiconductor device according to claim 13,
wherein said soldering process performs heating of the laminate body for 5 seconds or longer.

18. The method of manufacturing the semiconductor device according to claim 13,
wherein said laminate body forming process uses material selected from the groups consisting of copper, gold, silver, a gold and palladium based alloy containing gold and palladium as main constituents, and a silver and palladium based alloy containing silver and palladium as main constituents, as a metal thin film.
